# EUROPEAN PATENT SPECIFICATION

(11) **EP 0 377 101 B1**
(45) Date of publication and mention of the grant of the patent: **19.01.1994**
(21) Application number: 89121331.6
(22) Date of filing: 17.11.1989
(51) Int. Cl.: H01L 23/544

(54) **A reference mark structure for guiding the alignment of unfinished semiconductor integrated circuits topographies to successive masks**
Referenzmarkierungsstruktur zur Justierung der Ausrichtung von unfertigen Topographien von integrierten Halbleiterschaltungen in Bezug auf aufeinanderfolgende Masken
Repère pour guider l'alignement des topographies des circuits intégrés semi-conducteurs incomplets à des masques successifs

(30) Priority: 30.12.1988 IT 2317688
(43) Date of publication of application: 11.07.1990
(73) Proprietor: SGS-THOMSON MICROELECTRONICS s.r.l., 20041 Agrate Brianza (Milano) (IT)
(72) Inventor: Buraschi, Marco Ivano, I-20091 Bresso (Milan) (IT)
(74) Representative: Perani, Aurelio

(56) References cited:
- PATENT ABSTRACTS OF JAPAN, vol. 11, no. 367 (E-561), 28th November 1987; & JP-A-62 140 431
- PATENT ABSTRACTS OF JAPAN, vol. 12, no. 403 (E-674), 26th October 1988; & JP-A-63 144 545

## Description

This invention relates to a reference mark structure for guiding the alignment and true superposition of a mask to an unfinished semiconductor integrated circuit topography during the manufacturing process of said integrated circuit on a silicon wafer, said mark being formed over a field oxide surface region and comprising a step-like uneveness produced on the surface of said silicon wafer, as specified in the preamble of claim 1.

As is known, the manufacturing process of semiconductor integrated circuits involves preparation of a set of overlaid interdependent layers of circuit topographies. Each topography is obtained by a photolithographic process which usually involves masking , photographic development and subsequent selective etching of a silicon substrate referred to as the wafer. In this way, zones or regions are defined which may be enriched with impurities effective to dope the semiconductor such as to vary the conductivity thereof and result in the formation of a topography having a predetermined layout.

The importance to such a field of application of having the masks which define the layout of the additional circuit layers to be formed superposed on topographies previously formed on the silicon wafer, so as to achieve true alignment and agreement thereof, is self-evident.

This requirement, which is common to the manufacture of all semiconductor integrated circuits, becomes stricter in the field of CMOS circuit manufacture, and specifically in the manufacture of non-volatile memories of the EPROM type.

One of the most critical aspects of the manufacture of such circuits is the alignment of the mask of the contacts to the corresponding drain regions. It is a well-known fact, in this respect, that after the drain and source regions have been implanted in self-aligned form using the screen provided by the previously defined gate, the masking arrangement must be accurately positioned relatively to the gate in order to form the contacts on the drain regions. Any error made during this locating and aligning step can imperil the quality and performance of the circuit.

For guiding the alignment and true superposition of unfinished topographies and layout masks, prior techniques provide for the use of marks or references consisting of substantially step-like surface irregularities in cross-section which are formed on the silicon wafer surface affected by the topography.

To collimate the masks and topographies together, some sophisticated laser beam optical scanners are employed which can detect the exact position of a reference mark based on the intensity of the diffracted light from the side surface of the mark when illuminated by the laser beam.

A mark made in accordance with prior art techniques may comprise a layer of polycrystalline silicon overlying the gate oxide of the transistor and being covered with a layer of metallic silicide.

This prior technique, while substantially achieving its object, has a drawback in that, following selective etching to define the step-like construction of the mark, the gate oxide layer, which is as low as 20 nm (200 Ångstrom) in thickness, may prove inadequate to resist the etching. This results in an undesirable pit effect at the step base and formation of of an uneven substrate along the sides of the step. When the laser beam scans the topography in order to identify the mark location, the mark will refract a "noisy" signal which may make the measurement, and hence the alignment operation, ineffective.

Furthermore, reference marks formed in accordance with the prior art are not much elevated on the wafer surface, which makes their identification more difficult. From publication JP-A-62140431 a mark structure corresponding to the preamble of claim 1 is known which is formed on a field oxide region and comprises a step-like uneveness covered by an aluminium layer; the aluminium coated sides of the structure are used for reflecting a laser beam.

From publication JP-A-63144545 a mark structure is known comprising a metal silicide layer as its uppermost layer.

The technical problem that underlies this invention is to provide a novel reference mark structure for guiding the alignment and true superposition of unfinished topographies of semiconductor integrated circuits to their related processing masks during the manufacture of such circuits, which has such constructional and performance characteristics as to overcome the drawbacks mentioned above in connection with the prior art.

The technical problem is solved by a reference mark structure of the kind specified at the beginning of this description, which is characterized in that it comprises first and second layers of polycrystalline silicon arranged to overlie and contact each other and being covered with a layer of metallic silicide, said three layers having exposed aligned sides.

In a preferred embodiment, such layers are superposed on a gate oxide layer overlying said field oxide region.

The features and advantages of the inventive structure will become apparent from the following detailed description of an embodiment thereof, given by way of example and not of limitation with reference to the accompanying drawing.

In the drawing:
Figures 1 to 3 are respective side elevation views schematically illustrating in section manufacturing steps culminating in a reference mark structure according to the invention; and

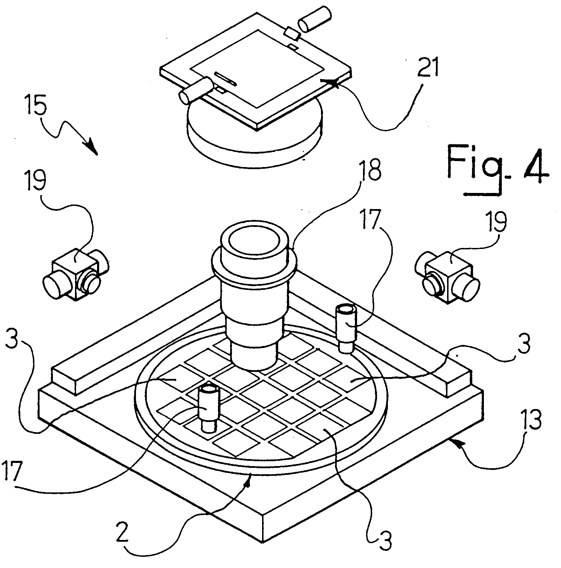

Figure 4 is a perspective view showing schematically an optical scanner apparatus for scanning the topography of integrated circuits incorporating the structure of Figure 1.

With reference to the drawing views, indicated at 1 is a layer of monocrystalline silicon defining the semiconductor substrate of a silicon wafer 2 on which integrated circuits 3, referred to as chips, are formed.

Indicated at 15 is a laser beam optical scanner apparatus, known per se, which comprises a stand 13 for supporting a wafer 2 being guided for movement on a horizontal plane. The apparatus 15 also incorporates a conventional mask 21 on which the layout of circuit topographies to be formed on the wafer 2 is reproduced.

The apparatus 15 enables automatic alignment and accurate superposition of the mask 21 to/on the unfinished topographies already formed on the wafer 2, by means of an electronic aligning device 8 which comprises manual pre-alignment optics 17, a projection objective 18, and laser emitters 19 operative to emit a laser beam toward the surface of the wafer 2.

That apparatus 15 can perform the alignment by picking up reference marks 20 formed in accordance with the invention as explained herein below.

Active areas 4 are formed on the substrate 1 which are suitably doped, e.g. with a source-drain region bound by isolating regions 14 covered by a top layer of so-called field oxide 5.

On this base structure there is grown a layer 6 of gate oxide whose thickness may vary between 15 and 40 nm (150 and 400 Ångstrom), for example, in order to provide memory cells of the EPROM type consisting of CMOS devices.

Deposited over the gate oxide is a first layer 7 of polycrystalline silicon having a thickness of approximately 200 nm (2000 Ångstrom).

That layer 7 is subsequently covered with a so-called interpoly isolating layer 8.

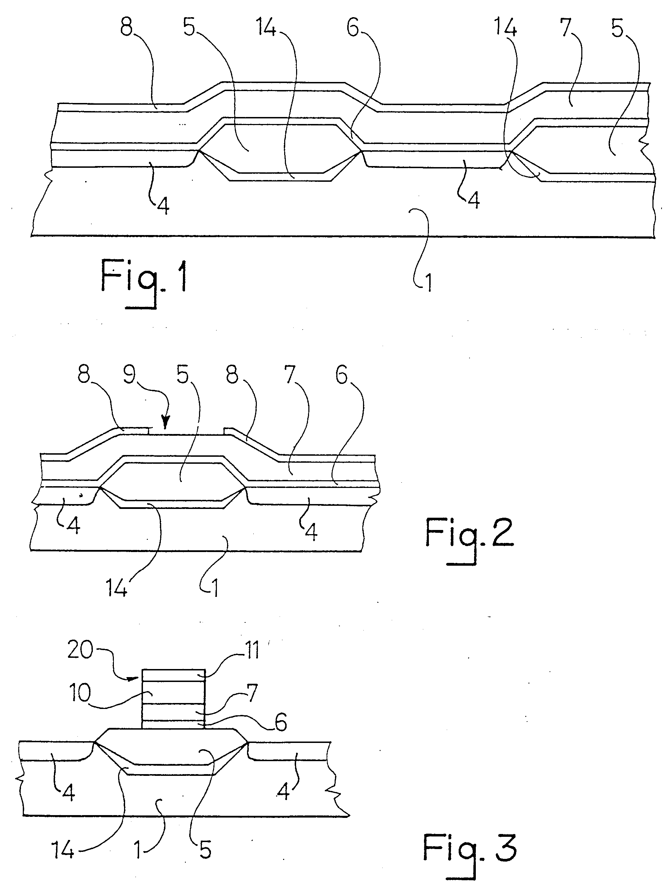

The isolating layer 8 is then subjected to a masking and selective etching to uncover the polycrystalline silicon layer 7 limited to windows 9 which are formed over the field oxide 5 as shown in Figure 2. At said windows 9, there is first deposited on the layer 7 a second interconnection layer 10 of polycrystalline silicon followed by an overlying final layer 11 of metallic silicide.

These additional layers 10 and 11 have a combined thickness of about 450 nm (4500 Ångstrom).

A further step of the manufacturing process provides for selective etching of the dual layer 7 and 10 of polycrystalline silicon in short circuit until a substantially step-like structure which constitutes said reference mark 20 and stands on a base formed by the field oxide 5 used as an etch-stop in the selective etching step, as shown in Figure 3.

The structure of this invention has a major advantage in that it affords definition of reference marks 20 of larger size than the wavelength used by the laser optical scanner apparatus 15 during the mark pick-up step. In addition, the "noise" brought about by refraction of the laser beam at the base of the monolithic shape is reduced considerably.

These advantages reflect on improved visibility of the reference marks and ensuing considerable reduction of the likelihood for misalignment between the contacts and the drain regions of the transistors of the CMOS circuits, and consequently less faults to be found in the integrated circuit thus produced.

## Claims

1. A reference mark structure for guiding the alignment and true superposition of a mask (21) to an unfinished semiconductor integrated circuit (3) topography during the manufacturing process of said integrated circuit on a silicon wafer (2), said mark structure (20) being formed over a field oxide surface region (5) and comprising a step-like uneveness produced on the surface of said silicon wafer (2) and being characterized in that it comprises first (7) and second (10) layers of polycrystalline silicon arranged to overlie and contact each other and being covered with a layer (11) of metallic silicide, said three layers having exposed aligned sides.

2. A structure according to Claim 1, characterized in that said three layers (7,10,11) overlie a gate oxide layer (6) placed over the field oxide region (5).

3. A structure according to Claim 2, characterized in that it is elevated above the field oxide region (5) by about 665-690 nm.

## Patentansprüche

1. Eine Referenzmarkierungsstruktur zur Justierung der Ausrichtung und richtigen Überlagerung einer Maske (21) bezüglich einer unvollendeten integrierten Halbleiterschaltungstopographie (3) während des Herstellungsprozesses der integrierten Schaltung auf einem Siliziumwafer (2), wobei die Markierungsstruktur (20) auf einer Feldoxidoberflächenregion gebildet wird und aus einer stufenartigen Unebenheit besteht, die auf der Oberfläche des Siliziumwafers (2) erzeugt ist,
dadurch gekennzeichnet,
daß sie eine erste (7) und eine zweite (10) Schicht aus polykristallinem Silizium umfaßt, die angeordnet sind, um sich gegenseitig zu überlagern und zu kontaktieren und die mit einer Schicht (11) aus einer metallischen Siliziumverbindung bedeckt sind, wobei die drei Schichten zugänglich ausgerichtete Seiten haben.

2. Eine Struktur gemäß Anspruch 1, dadurch gekennzeichnet,
daß die drei Schichten (7, 10, 11) auf einer Gateoxidschicht (6) liegen, die auf der Feldoxidregion (5) liegt.

3. Eine Struktur gemäß Anspruch 2, dadurch gekennzeichnet,
daß sie über der Feldoxidregion (5) um etwa 665 bis 690 nm erhöht ist.

## Revendications

1. Une structure de marque de référence pour le guidage dans l'alignement et la superposition exacte d'un masque (21) sur une topographie incomplète d'un circuit intégré à semiconducteurs (3), pendant le processus de fabrication de ce circuit intégré sur une tranche de silicium (2), cette structure de marque (20) étant formée sur une région de surface d'oxyde de champ (5) et consistant en une inégalité semblable à une marche qui est formée sur la surface de la tranche de silicium (2), et étant caractérisée en ce qu'elle comprend une première couche (7) et une seconde couche (10) de silicium polycristallin disposées de façon à se recouvrir et à être en contact mutuel, et qui sont recouvertes par une couche (11) de siliciure métallique, ces trois couches ayant des côtés alignés à nu.

2. Une structure selon la revendication 1, caractérisée en ce que les trois couches (7, 10, 11) recouvrent une couche d'oxyde de grille (6) qui est placée sur la région d'oxyde de champ (5).

3. Une structure selon la revendication 2, caractérisée en ce qu'elle s'élève d'environ 665-690 nm au-dessus de la région d'oxyde de champ (5).
